# FASCICULE DE BREVET EUROPEEN

(11) **EP 1 311 904 B1**
(45) Date de publication et mention de la délivrance du brevet: **16.06.2004**
(21) Numéro de dépôt: 01969492.6
(22) Date de dépôt: 23.07.2001
(51) Int. Cl.: G03B 17/12, G03B 17/28, H04N 5/225, H04N 5/335

(54) **APPAREIL DE PRISE D'IMAGES DE PETITES DIMENSIONS, NOTAMMENT APPAREIL PHOTOGRAPHIQUE OU CAMERA**
VORRICHTUNG ZUR AUFNAHME VON BILDERN KLEINER ABMESSUNGEN, INSBESONDERE PHOTOAPPARAT ODER VIDEOKAMERA
SMALL-SIZE IMAGING APPARATUS, IN PARTICULAR PHOTOGRAPHIC APPLIANCE OR CAMERA

(30) Priorité: 11.08.2000 EP 00202834
(43) Date de publication de la demande: 21.05.2003
(73) Titulaire: EM Microelectronic-Marin SA, 2074 Marin (CH)
(72) Inventeur: DOERING, Elko, CH-2572 Mörigen (CH); GRUPP, Joachim, CH-2073 Enges (CH); PFEFFERLI, Beat, CH-2075 Thielle-Wavre (CH)
(74) Mandataire: Surmely, Gérard
(86) Numéro de dépôt international: PCT/EP2001/008533
(87) Numéro de publication internationale: WO 2002/014949

(56) Documents cités:
- WO-A-99/11056
- US-A- 5 130 804
- US-A- 5 221 964
- US-A- 6 011 661
- DATABASE WPI Section EI, Week 200067 Derwent Publications Ltd., London, GB; Class T04, AN 2000-681661 XP002158824 -& JP 2000 196808 A (KYOCERA CORP), 14 juillet 2000 (2000-07-14)
- PATENT ABSTRACTS OF JAPAN vol. 2000, no. 07, 29 septembre 2000 (2000-09-29) -& JP 2000 111777 A (TAIHEIYO BOEKI KK), 21 avril 2000 (2000-04-21)
- PATENT ABSTRACTS OF JAPAN vol. 1999, no. 11, 30 septembre 1999 (1999-09-30) -& JP 11 167054 A (MATSUSHITA ELECTRIC IND CO LTD), 22 juin 1999 (1999-06-22)

## Description

La présente invention concerne un appareil de prise d'images de petites dimensions, notamment un appareil photographique ou une caméra, dans lequel il est prévu un capteur formé d'une pluralité de pixels servant à la détection d'images. Cet appareil comprend au moins une lentille de focalisation dont l'axe optique croise sensiblement le centre géométrique de la surface photosensible du capteur.

En particulier, l'appareil de prise de vue selon l'invention est destiné à être incorporé dans un dispositif portable multifonctionnel, notamment un téléphone mobile, une montre ou un micro-ordinateur portable.

Le document US 6,011,661 divulgue un appareil de prise d'images avec un support d'éléments optiques destiné à recevoir d'un côté un objectif présentant un filetage pour un assemblage par vissage à ce support, et de l'autre côté un filtre et un capteur CCD. Le support présente une ouverture traversante et des moyens de positionnement du capteur CCD relativement à l'objectif vissé dans ce support.

Il est connu du document US 5,130,804 un appareil de prise d'images comprenant un capteur, une lentille agencée dans un châssis et un support présentant une ouverture en regard de laquelle sont agencées de part et d'autre de ce support la lentille et une surface photosensible dudit capteur. Le capteur lui-même est formé d'un substrat définissant la surface photosensible, ce substrat étant agencé au fond d'un boîtier auquel il est relié électriquement de manière classique. Ce boîtier comprend des liaisons électriques reliant le substrat à des plages de contact externes du boîtier pour permettre une connexion électrique audit support sur lequel est monté des unités électroniques. Cet appareil présente un inconvénient car il n'est pas aisé lors de son montage d'aligner précisément l'axe optique de l'objectif et le centre de l'ouverture. De même, le positionnement du capteur relativement à cette ouverture n'est pas assuré. De plus, il n'est pas aisé de monter le capteur sur le support en assurant que les plages de contact correspondantes soient correctement en vis-à-vis.

Le but de la présente invention est de pallier les inconvénients mentionnés ci-dessus.

A cet effet, l'invention concerne un appareil de prise d'images tel que défini à la revendication 1 ci-jointe.

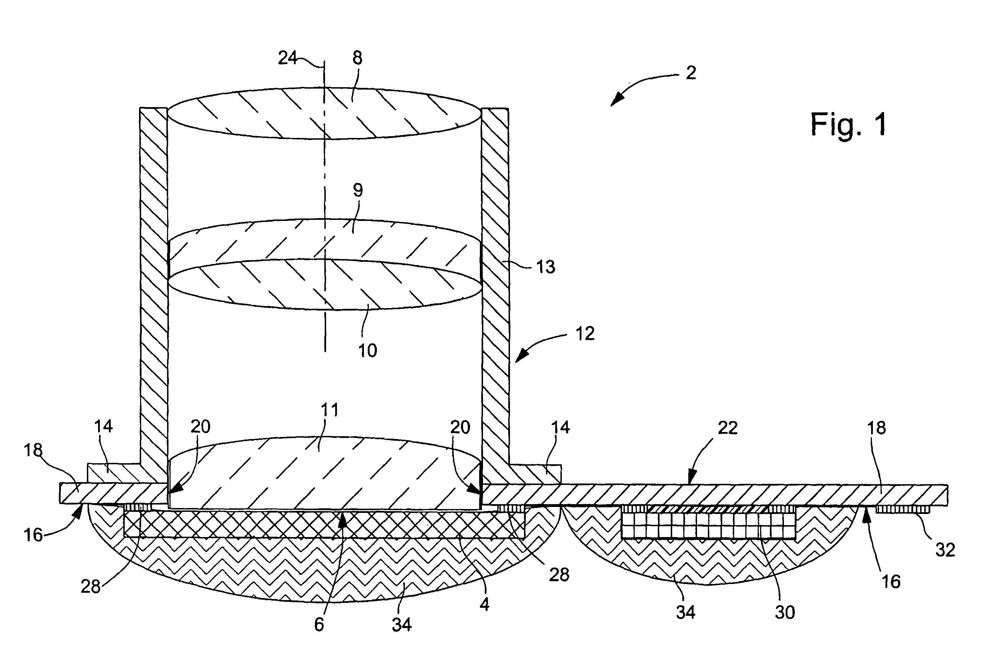

La présente invention sera décrite ci-après en détail à l'aide de la description suivante, faite en référence à la figure 1 qui représente schématiquement un mode de réalisation de l'appareil de prise d'images selon l'invention, donné à titre d'exemple nullement limitatif.

Sur la figure 1 est représenté schématiquement un appareil de prise d'images 2 formant un module compact et autonome. Cependant, il est destiné à être intégré dans un dispositif portable, notamment un téléphone ou un objet portable au

Sur la figure 1 est représenté schématiquement un appareil de prise d'images 2 formant un module compact et autonome. Cependant, il est destiné à être intégré dans un dispositif portable, notamment un téléphone ou un objet portable au poignet comme une montre. Cet appareil est formé d'un capteur d'images 4 présentant une surface photosensible 6 et d'un objectif comprenant des lentilles de focalisation 8, 9, 10 et 11 au moins partiellement montées dans un châssis 12, lequel définit un tube 13 présentant une ouverture traversante et un flasque 14 situé au niveau de l'extrémité interne du tube, c'est-à-dire du côté du capteur. L'extrémité externe du tube est fermé par la lentille 8. Le capteur 4 est monté sur la face inférieure 16 d'un support 18 qui présente une ouverture 20 aux dimensions sensiblement égales ou supérieures à celles de la surface photosensible 6, laquelle est située en regard de l'ouverture 20 de manière sensiblement centrée sur cette dernière.

On notera que certaines lentilles peuvent également avoir une fonction de filtre infrarouge ou ultraviolet, en particulier la lentille 11. Dans une variante de réalisation, l'élément optique 11 est formé seulement par un filtre présentant deux faces parallèles plates. L'élément optique 11 peut être fixé soit au châssis 12 de l'objectif, soit au substrat 18 en étant par exemple simplement chassé dans l'ouverture 20, soit encore être fixé directement au capteur 4. Ces diverses possibilités permettent des variantes de réalisation pour l'homme du métier.

Selon l'invention, il est prévu des moyens de positionnement de l'objectif, lors de son montage, relativement à l'ouverture 20 et/ou au capteur 4. Dans un mode de réalisation préféré, ces moyens de positionnement servent également au positionnement du capteur relativement à ladite ouverture, de sorte que l'axe optique 24 de l'objectif et le centre de la surface photosensible du capteur sont sensiblement alignés.

Dans le premier mode de réalisation préféré, lesdits moyens de positionnement sont formés par l'élément optique 11 qui est agencé fixement dans l'ouverture 20 avec sa paroi latérale s'élevant au-dessus de la face supérieure 22 du support 18. Les dimensions de l'ouverture 20 sont déterminées de manière que l'élément optique soit positionné dans cette ouverture par la paroi de cette dernière.

Dans une variante où l'élément optique 11 est fixé au capteur 4 avant le montage, cet élément permet de positionner ce capteur lors de son montage sur le substrat 18. De plus, dans ce cas, l'élément 11 sert au positionnement du châssis 12 et donc de l'objectif relativement au capteur 4. Par exemple, l'élément 11 est collé sur la surface photosensible 6. Cette variante n'exclut pas que l'ouverture 20 ait des dimensions supérieures à celles de l'élément optique 11.

On notera encore que le châssis 12 est représenté ici de manière schématique et qu'il peut présenter diverses formes et en particulier avoir un profil interne ou externe non rectiligne. Le châssis 12 peut être fixé au substrat 18 de diverses manières à disposition de l'homme du métier, notamment par collage.

Le capteur 4 est formé d'un substrat semiconducteur à la surface duquel sont agencés des pixels définissant la surface photosensible 6. Ces pixels sont reliés par des pistes électriques à des plots 28 de contact électrique avec des plages correspondantes agencées à la face inférieure 16 du support. A cette face 16 sont agencées diverses pistes conductrices reliant les plages de contact au capteur 4 avec au moins une unité électronique 30. Des plages de contact périphériques 32 peuvent également être prévues pour fournir les images traitées ou partiellement traitées à des moyens d'exploitation, notamment des moyens d'affichage des images prises par l'appareil 2.

Le capteur 4 et l'unité électronique 30 sont protégés au moyen d'une résine 34. Cette résine 34 rigidifie également la partie arrière du substrat 18 et assure le maintien des liaisons électriques entre les plages de contact agencées sur le substrat 18 et les plages ou plots de connexion 28 du capteur. On notera en effet que le capteur 4 peut ne présenter que des plages de contact formées d'une fine métallisation en surface, la connexion électrique étant réalisée au moyen d'une colle conductrice anisotrope ou d'un autre moyen intermédiaire connu de l'homme du métier.

On notera finalement que le support 18 peut avantageusement avoir une partie souple pliable entre une première partie supportant le capteur et l'objectif et une deuxième partie supportant d'autres unités, notamment l'unité électronique 30. Ceci permet de rabattre la deuxième partie sous la première partie pour obtenir un appareil très compact où l'unité 30 est notamment située en regard du capteur 4, dans le prolongement de l'objectif.

## Revendications

1. Appareil de prise d'images de petites dimensions formé d'un capteur (4) et d'un objectif (8, 9, 10, 12) agencés respectivement de part et d'autre d'un support (18) présentant une ouverture (20) pour le passage de lumière focalisée par ledit objectif, ledit capteur ayant une surface photosensible (6) située en regard de ladite ouverture, cet appareil comprenant des moyens de positionnement (11) dudit objectif, lors de son montage, relativement à ladite ouverture et/ou audit capteur, ledit objectif étant formé d'un châssis (12) dans lequel est agencé au moins un premier élément optique (8, 9, 10), ce châssis présentant une ouverture traversante avec une extrémité externe fermée par ce premier élément optique et une extrémité interne située en regard de ladite ouverture, **caractérisé en ce que** cet appareil comprend un deuxième élément optique (11) agencé au moins partiellement dans ladite ouverture dudit support et formant lesdits moyens de positionnement de l'objectif.

2. Appareil selon la revendication 1, **caractérisé en ce que** lesdits moyens de positionnement (11) servent également au positionnement dudit capteur, lors de son montage, relativement à ladite ouverture de sorte que l'axe optique (24) dudit objectif et le centre de ladite surface photosensible sont sensiblement alignés.

3. Appareil selon la revendication 2, **caractérisé en ce que** ledit deuxième élément optique est collé sur ladite surface photosensible avant le montage dudit capteur sur ledit support.

4. Appareil selon l'une des revendications précédentes, **caractérisé en ce que** les dimensions de ladite ouverture sont déterminées pour que ledit deuxième élément optique soit positionné dans cette ouverture par leurs parois latérales respectives.

## Patentansprüche

1. Bildaufnahmevorrichtung mit kleinen Abmessungen, die gebildet ist aus einem Sensor (4) und aus einem Objektiv (8, 9, 10, 12), die auf der einen bzw. auf der anderen Seite eines Träger (18) angeordnet sind, der eine Öffnung (20) für den Durchgang von durch das Objektiv fokussiertem Licht aufweist, wobei der Sensor eine lichtempfindliche Oberfläche (6) besitzt, die sich gegenüber der Öffnung befindet, wobei diese Vorrichtung Mittel (11) zum Positionieren des Objektivs bei seiner Montage in Bezug auf die Öffnung und/oder den Sensor umfasst, wobei das Objektiv aus einem Rahmen (12) gebildet ist, in dem wenigstens ein erstes optisches Element (8, 9, 10) angeordnet ist, wobei dieser Rahmen eine Durchgangsöffnung aufweist, wovon ein äußeres Ende durch dieses erste optische Element verschlossen ist und wovon sich ein inneres Ende gegenüber der Öffnung befindet, **dadurch gekennzeichnet, dass** diese Vorrichtung ein zweites optisches Element (11) umfasst, das wenigstens teilweise in der Öffnung des Trägers angeordnet ist und die Mittel für die Positionierung des Objektivs bildet.

2. Vorrichtung nach Anspruch 1, **dadurch gekennzeichnet, dass** die Positionierungsmittel (11) auch der Positionierung des Sensors bei seiner Montage in Bezug auf die Öffnung dienen, derart, dass die optische Achse (24) des Objektivs und das Zentrum der lichtempfindlichen Oberfläche im Wesentlichen aufeinander ausgerichtet sind.

3. Vorrichtung nach Anspruch 2, **dadurch gekennzeichnet, dass** das zweite optische Element vor der Montage des Sensors am Träger auf die lichtempfindliche Oberfläche geklebt wird.

4. Vorrichtung nach einem der vorhergehenden Ansprüche, **dadurch gekennzeichnet, dass** die Abmessungen der Öffnung so bestimmt sind, dass das zweite optische Element in dieser Öffnung mittels ihrer jeweiligen Seitenwände positioniert ist.

## Claims

1. Image recording apparatus of small dimensions formed of a sensor (4) and a lens assembly (8, 9, 10, 12) arranged respectively on either side of a support (18) having an aperture (20) for the passage of light focussed by said lens assembly, said sensor having a photosensitive surface (6) located facing said aperture, said apparatus including means for positioning (11) said lens assembly, during assembly thereof, relative to said aperture and/or said sensor, said lens assembly being formed of a frame (12) in which a first optical element is arranged (8, 9, 10), said frame having a through aperture with an external end closed by said first optical element and an inner end located facing said aperture, **characterised in that** said apparatus includes a second optical element (11) at least partially arranged in said aperture of said support and forming said positioning means of the lens assembly.

2. Apparatus according to claim 1, **characterised in that** said positioning means (11) are also used for positioning said sensor, during assembly thereof, relative to said aperture, such that the optical axis (24) of said lens assembly and the centre of said photosensitive surface are substantially aligned.

3. Apparatus according to claim 2, **characterised in that** said optical element is bonded onto said photosensitive surface before said sensor is mounted on said support.

4. Apparatus according to any of the preceding claims, **characterised in that** the dimensions of said aperture are determined such that said optical element is positioned in said aperture by their respective lateral walls.
